Europäisches Patentamt

European Patent Office

Office européen des brevets

(11) Numéro de publication: **0 277 460**

**A1**

## (12) DEMANDE DE BREVET EUROPEEN

(21) Numéro de dépôt: **87810729.1**

(22) Date de dépôt: **09.12.87**

(51) Int. Cl.⁴: **H01J 37/32** , C25D 5/34

(30) Priorité: **16.12.86 CH 4995/86**

(43) Date de publication de la demande:
**10.08.88 Bulletin 88/32**

(84) Etats contractants désignés:
**AT BE CH DE ES FR GB GR IT LI LU NL SE**

(71) Demandeur: **Plasma-Seven S.A.**
**Au Chateau**
**CH-2028 Vaumarcus(CH)**

(72) Inventeur: **Ashdown, Ian**
**Route Haute 56**
**CH-1422 Grandson(CH)**

(74) Mandataire: **Rochat, Daniel Jean et al**
**Bovard SA Ingénieurs-conseils ACP**
**Optingenstrasse 16**
**CH-3000 Bern 25(CH)**

(54) **Procédé pour la restitution d'une structure métallique dans une surface dégradée d'un objet en métal, application de ce procédé et dispositif pour la mise en oeuvre du procédé.**

(57) L'enceinte (1) qui contient les objets (3) est occupée par de l'hydrogène ou un mélange d'hydrogène et de gaz neutre à basse pression. Ce gaz est ionisé par l'émission du ou des magnétrons (11) guidée par la pièce tubulaire (10) et se réflechissant sur les parois de l'enceinte (1). Les produits de corrosion ou d'oxydation présents à la surface des objets (3) sont réduits par l'hydrogène ionisé et donnent des résidus faciles à éliminer mécaniquement. Les procédé s'applique également comme prétraitement sur des pièces fraichement usinées.

FIG. 1

EP 0 277 460 A1

## Procédé pour la restitution d'une structure métallique dans une surface dégradée d'un objet en métal, application de ce procédé et dispositif pour la mise en oeuvre du procédé.

La présente invention se rapporte à des perfectionnements et des développements décisifs dans le domaine du traitement des surfaces d'objets métalliques. On sait que toute surface métallique mise en présence d'un environnement en phase gazeuse est le siège de réactions entre le métal et les atomes du gaz. Ceci conduit, notamment dans le cas de pièces métalliques fraichement usinées, mises en présence de l'air, à la formation de couches d'oxydes. Un autre cas particulier de ces phénomènes est celui qui se rapporte aux objets métalliques ayant séjournés très longtemps, par exemple pendant plusieurs siècles, dans un environnement naturel. En général, la surface de ces objets a été corrodée par différents agents chimiques et lorsque ces objets présentent un intérêt historique, archéologique ou artistique, on désire souvent restaurer leur aspect extérieur. Les études et recherches historiques, artistiques, ou archéologiques, exigent aujourd'hui la mise en oeuvre de procédés capables d'éliminer la corrosion superficielle sur de tels objets et on connait notamment par un article de Patscheider et Veprek paru dans "The Journal of the international Institute for Conservation of historic and artistic works" paru en février 1986 un procédé consistant à créer dans une enceinte contenant des objets à traiter un plasma d'hydrogène à basse pression qui est entretenu par une émission d'ondes électro-magnétiques d'une fréquence de l'ordre de 80 MHz.

Cependant l'action réductrice d'un plasma d'hydrogène à basse pression excité par des émissions d'ondes électro-magnétiques sur la surface d'objets métalliques est connu dans d'autres domaines et à été utilisée industriellement de diverses manières. Ainsi, selon le brevet d'Union Soviétique No. 932 570 on a proposé de faire agir un plasma d'hydrogène excité par l'émission d'un magnetron à micro-ondes, sur la surface d'un élément ferrite afin de restituer une surface métallique susceptible d'être usinée avec une précision telle que les aspérités de surface ne dépassent pas 1 micron, après quoi la surface est réoxydée.

D'autre part, selon le document DE-OS 30 11 686, il est connu dans un but de nitruration, de cémentation ou de décapage, de soumettre une surface de certaines pièces à l'action réductrice d'une atmosphère d'hydrogène à basse pression excitée à l'état de plasma par une émission de micro-ondes d'une fréquence de 2400 à 2450 MHz. Le dispositif prévu pour cela comporte à l'intérieur d'une enceinte étanche dans laquelle on établit l'atmosphère d'hydrogène à basse pression désirée, un support cylindrique en quartz dont la face interne porte les pièces à traiter et à l'intérieur de ce support une gaine également en quartz qui pénètre dans l'enceinte et dont l'espace intérieur est raccordé à un guide d'ondes relié lui-même au générateur de micro-ondes placé à l'extérieur de l'enceinte. Ainsi l'énergie d'excitation, conduite dans la gaine par une antenne provoque le rayonnent de la gaine et l'émission d'ondes dirigées radialement, qui sont absorbées par le support cylindrique des pièces.

Cependant l'application d'une méthode de ce genre à la réfection de surfaces dégradées par des composés d'autres éléments que l'oxygène, comme le chlore, notamment, n'était pas connue et d'autre part les documents antérieurs ne comportent aucun enseignement ni aucune suggestion au sujet des effets thermiques découlant de l'excition du plasma, ou la manière dont ces effets peuvent être maîtrisés.

La présente invention résulte de la découverte qu'un effet très prononcé de réduction de produits de corrosion, notamment d'oxydes, mais aussi de chlorures, peut être obenu d'une manière beaucoup plus efficace et à des frais nettement plus bas qu'avec les procédés connus, grâce à un choix judicieux des fréquences des ondes utilisées et grâce à une disposition constructive adéquate de l'appareil.

Ainsi donc, un objet de la présente invention est un procédé pour la restitution d'une structure métallique dans une surface dégradée d'un objet en métal par une action réductrice d'une atmosphère d'hydrogène à basse pression activée par une émission d'ondes électro-magnétiques à haute fréquence, caractérisé en ce que les ondes électro-magnétiques utilisées ont une fréquence choisie dans l'une de plusieurs bandes efficaces situées au-dessus de 400 MHz, en ce que les objets sont placés dans une enceinte dont les parois ont une action réfléchissante sur les ondes qui les frappent et en ce que la température des objets est réglée pendant la durée du traitement.

Les travaux à l'origine de la présente invention ont encore conduit à une autre découverte consistant en ce que le coût de la mise en oeuvre du procédé et la qualité des résultats obtenus étaient si favorables que le procédé était applicable dans le domaine industriel comme prétraitement de pièces fraichement produites en vue d'un traitement de surface définitif.

Ainsi donc un autre objet de l'invention est une application du procédé à un prétraitement de la surface d'un objet métallique, ce prétraitement étant destiné à préparer l'objet en vue de la formation d'un revêtement par dépôt électrolytique, dépôt d'un enduit, projection de particules chargées ou non, etc.

Finalement, la présente invention a pour objet un appareil pour la mise en oeuvre du procédé, comprenant une enceinte contenant des moyens de support d'objets à traiter, une pompe à vide, une source d'hydrogène, et un dispositif émetteur d'ondes électro-magnétiques, caractérisé en ce que le dit dispositif émetteur est agencé pour émettre dans au moins l'une de plusieurs bandes efficaces situées au-dessus de 400 MHz, en ce que l'enceinte est entièrement constituée de parois réfléchissant les dites ondes et en ce que les moyens de support sont agencés pour maintenir les objets à distance des parois de l'enceinte.

L'invention sera expliquée ci-après sur la base de deux exemples de réalisation de l'appareil pour la mise en oeuvre du procédé.

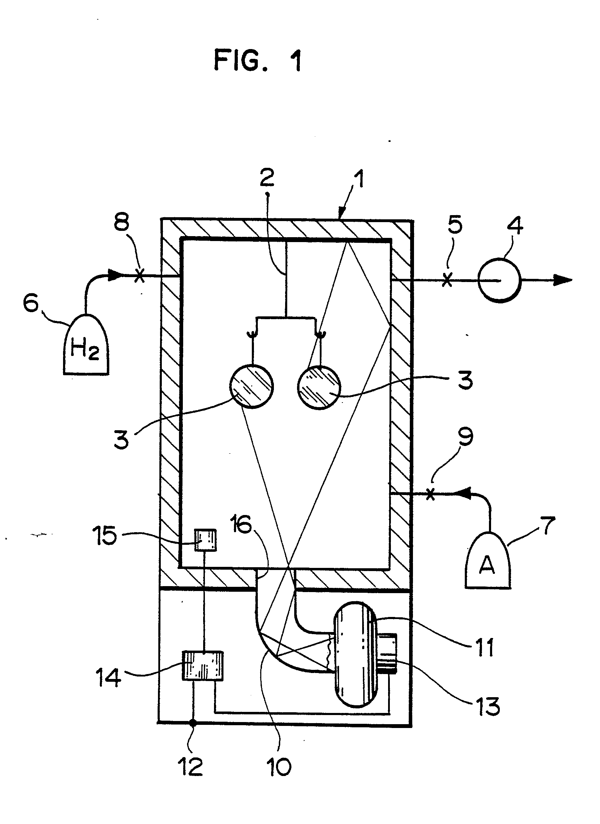

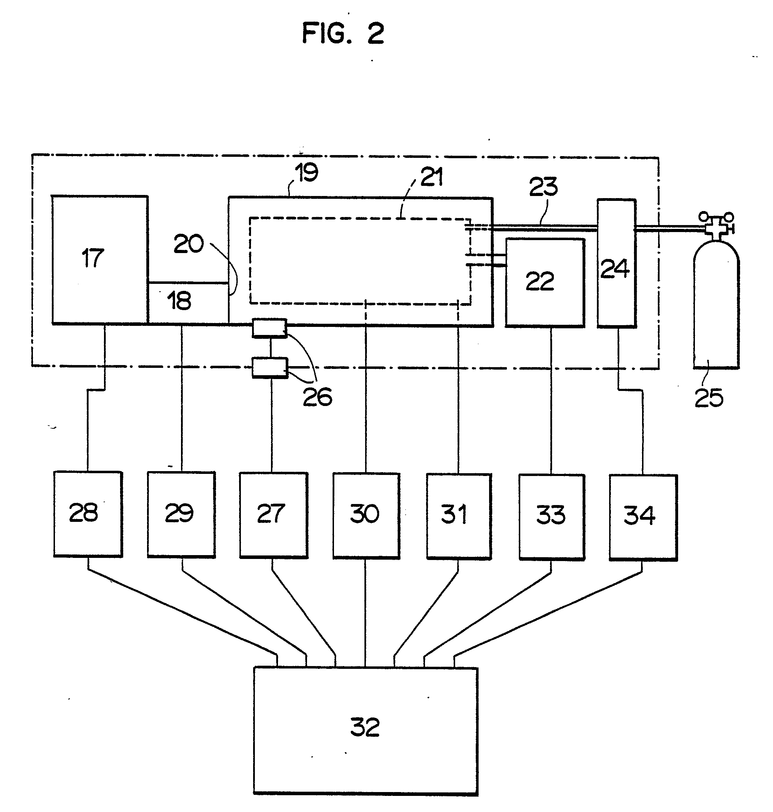

Les fig. 1 et 2 du dessin annexé sont des vues schématiques de ces deux formes d'exécution.

La fig. 1 représente de façon très schématique une enceinte 1 dont les parois seront de préférence en aluminium, dans laquelle est aménagé un support 2 auquel peuvent être suspendus un ou plusieurs objets 3 destinés à être traités. Une pompe à vide 4 capable de réaliser dans une enceinte telle que l'enceinte 1 un vide allant jusqu'à 10⁻³ mbar est destiné à en extraire l'air. Une vanne 5, à laminage, permettant un réglage du débit aspiré par la pompe, est prévue dans la conduite d'aspiration de la pompe 4. A l'enceinte 1 sont encore raccordés un réservoir d'hydrogène 6 et un réservoir de gaz inerte 7 contenant par exemple de l'argon ou un autre gaz neutre. Des vannes 8 et 9 permettent de régler l'admission des gaz des réservoirs 6 et 7 dans l'enceinte 1. Bien que les réservoirs soient raccordés séparément à l'enceinte, dans le dessin, la réalisation pratique comportera plutôt un raccord d'entrée commun, connecté aux deux réservoirs.

Dans le fond de l'enceinte 1 débouche un guide d'ondes 10 qui est raccordé à une source de rayonnement électro-magnétique 11 susceptible d'être excitée à partir d'une connection d'entrée 12 par un circuit d'excitation 13. Comme source de rayonnement efficace on utilise selon les dimensions de l'enceinte un ou plusieurs générateurs espacés le long du fond de l'enceinte. Chaque magnétron 11 possède une cavité qui est reliée par un guide d'ondes 10 à une ouverture 16 ménagée dans une paroi de l'enceinte. On peut aussi prévoir entre chaque générateur et la paroi de l'enceinte, un câble coaxial. Un interrupteur 14 commandé par un thermostat 15 installé dans l'enceinte 1 permet de commander et de régler le fonctionnement de la source 11.

Pour régler la température, on peut aussi prévoir une commande par impulsions sur le ou les générateurs 11. L'expérience montre que dans ce cas l'ionisation du gaz est améliorée par les chocs à chaque impulsion. L'efficacité de la source d'énergie électromagnétique est améliorée.

Une particularité importante du dispositif décrit est le fait que la source de rayonnement électromagnétique 11 est agencée de façon à émettre dans une ou plusieurs bandes de fréquence prédéterminées. De façon générale, la fréquence de la source sera supérieure à 400 MHz. Cependant on a constaté que certaines bandes de fréquence donnaient des résultats particulièrement favorables. Ainsi on a déterminé que les bandes suivantes pouvaient être choisies de préférence.

1 433.92 MHz

2 915 MHz

3 2'450 MHz

4 5'800 MHz

5 22'125 MHz

Ce choix a l'avantage de couvrir des fréquences qui sont toutes acceptées par les autorités de télécommunications et les autorités miliatires dans au moins un des principaux pays du monde.

Une autre particularité du dispositf décrit est le fait que l'énergie produite et le réglage du traitement peuvent être commandés grâce au thermostat 15. Par enclenchement et déclenchement alternatifs de la source électro-magnétique 11 on peut facilement maintenir la température de l'objet pendant le traitement à la valeur voulue. Des essais ont montré que le domaine de température dans lequel on pouvait travailler efficacement était compris par exemple entre 40°C et 300°C, pour la restauration d'objets corrodés.

La mise en oeuvre de procédé se déroule de la façon suivante:

1. On met en place les objets.

2. Au moyen de la pompe 4 on fait le vide à l'intérieur de l'enceinte 1.

3. On fait circuler dans cette enceinte un gaz inerte provenant du réservoir 7 afin d'éliminer toute trace d'oxygène, puis on ferme la vanne 9.

4. On introduit ensuite par la vanne 8 le gaz contenu dans le réservoir 6. Comme on l'a dit plus haut, on peut utiliser de l'hydrogène pur ou un mélange d'hydrogène et de gaz neutre, comme l'argon ou le néon. On a constaté qu'un mélange de 30% A.r / 70% $H_2$ par exemple donnait de bons résultats. La pression est réglée à 2 - 8 mbar.

5. On peut alors enclencher la source 11 constituée comme dit plus haut par un ou plusieurs magnétrons.

Comme le montre la figure, l'émission du générateur 11 est dirigée par le guide 10 dans l'enceinte 1 ou elle se réfléchit sur les parois de cette enceinte qui sont constituées et dont la géométrie est étudiée de façon que par une ou plusieurs réflexions successives ces ondes atteignent pratiquement tous les points de la surface des objets 3. Ainsi, dans toute l'enceinte 1, mais plus particulièrement au voisinage de la surface de ces objets, le gaz de réduction est excité par le rayonnement électro-magnétique et se transforme en un gaz atomique. Ces particules activées et/ou partiellement ionisées réagissent avec les produits de corrosion (O, Cl, OH etc.) qui s'en trouvent réduits.

Suivant les cas, le traitement peut durer d'environ 1 h jusqu'à plusieurs heures ou même plusieurs jours. Il suffit ensuite de retirer les objets. De préférence, avant d'ouvrir l'enceinte, on commence par aspirer l'hydrogène au moyen de la pompe à vide puis on remplace l'hydrogène par le gaz neutre, argon ou azote et on laisse remonter la pression. De ce fait, les objects se refroidissent à la température ambiante sans être en contact avec l'air et l'humidité ambiants. On notera que pour favoriser la dispersion des ondes on peut prévoir au voisinage de l'ouverture 16 un brasseur à pales en aluminium. Dans le cas d'objets archéologiques ou historiques, les résidus réduits seront enlevés par un procédé adéquat, par exemple mécanique, compatible avec le but visé et la nature de l'objet ainsi traité.

La fig. 2 représente schématiquement une forme d'exécution de l'appareil dans laquelle l'atmosphère de gaz réducteur à basse pression est confinée à l'intérieur d'un cloisonnement interne en verre au borosilicate. A la fig. 2 on voit en 17 un générateur de micro-ondes du même type que celui ou ceux décrits en relation avec la fig. 1. Ce générateur de micro-ondes transmet ses ondes par un guide 18 qui débouche dans une enceinte 19 ayant par exemple une forme de parallélépipède réctangle avec des parois planes à faces internes en aluminium. Cette enceinte est entièrement fermée. Elle possède par exemple un couvercle à sa partie supérieure, ce couvercle étant fermé de façon métalliquement jointive lorsqu'il est en place. Ainsi à l'intérieur de l'enceinte 19 existe une cavité de résonance. Les ondes débouchant dans la cavité de résonance par l'ouverture 20 se dispersent et se difractent dans la cavité en se réfléchissant sur les parois de l'enceinte. A l'intérieur de cette enceinte est prévu un cloisonnement 21 constitué par exemple par un cylindre en verre au borosilicate qui peut être placé avec son axe vertical et qui peut être fermé lorsqu'on met en place le couvercle de l'enceinte 19. L'intérieur de ce cloisonnement communique par exemple par le fond de l'enceinte ou par un côté avec une pompe à vide 22 d'une part, et avec une ou plusieurs conduites 23 d'autre part. La conduite 23 est reliée par l'intermédiaire d'une vanne de contrôle et de commande 24 à une alimentation 25 qui comporte d'une part un gaz réducteur comme l'hydrogène, et d'autre part un gaz neutre, azote ou argon. Seule une alimentation a été représentée pour simplifier le dessin. Les éléments 22 à 25 permettent d'évacuer l'air de l'enceinte 21 pour le remplacer soit par le gaz neutre, soit par le gaz réducteur, comme on l'a vue dans la première forme d'éxécution. Il résulte de la disposition décrite, que seul le volume de l'enceinte 21 doit être maintenu sous basse pression pendant le traitement, alors que le reste du volume de l'enceinte 19 peut être maintenu à l'air à la pression atmosphérique. Cette disposition simplifie sensiblement les problèmes d'étanchéité et permet d'autre part de dimensioner l'enceinte 19 de façon à permettre aux ondes sortant de l'ouverture 20 de se disperser dans tout le volume de l'enceinte 19, en traversant, le cas échéant plusieurs fois, la paroi 21.

Le schéma représente également les dispositifs de contrôle, de mesure et de commande prévus. Les éléments 26 placés d'une part dans une paroi de l'enceinte 19 et d'autre part dans le carénage général de l'appareil, sont des dispositifs de sécurité de fermeture. Ils sont reliés à un élément 27 de contrôle de fermeture. En 28, on voit un élément de contrôle du générateur 17, en 29 un élément de contrôle de retour des ondes dans le guide d'ondes 18, en 30 un élément de contrôle de la pression à l'intérieur du cloisonnement 21, en 31 un élément de contrôle de température qui capte la température d'une part à la paroi du cloisonnement 21, et d'autre part au niveau des objets placés à l'intérieur. Le contrôle de température 31 coopère, comme tous les autres éléments vus jusqu'à maintenant, avec le circuit de contrôle général 32 qui reçoit également les signaux de contrôle de la pompe à vide 33 et celui des vannes de commande 34.

Cette disposition permet de commander automatiquement le fonctionnement du dispositif pendant toute la durée du traitement, et cela principalement de façon à régler la températre selon un programme prédéterminé. On a constaté du fait que les ondes sont entièrement confinées à l'intérieur de l'enceinte 19, le rendement du dispositif était extrêmement élevé et que la posssibilité d'élever la température se présentait de façon très rapide. On peut donc régler la température à la valeur voulue en enclenchant et déclenchant périodiquement le générateur 17. Le réglage de température s'est révélé très important pour la restitution de surfaces métalliques sur des objets fortement corrodés, notamment lorsque les produits étrangers contiennent du chlore. Si la température est trop élevé il existe un risque que certaines particules métalliques soit éliminées au traitement, alors qu'une température correctement réglée permet par exemple d'éliminer les composés d'hydroxide et de chlore qui peuvent se présenter selon différentes formes plus ou moins difficiles à décomposer.

On a également remarqué que la température optimale dépend pour chaque objet de différents paramètres, mais notamment du pH des éléments de corrosion.

Du fait que l'on peut utiliser des générateurs de construction classique comme source d'énergie, l'ensemble de l'installation décrite atteint un prix de revient extraordinairement bas. L'application du procédé est donc extrêmement avantageuse, au point que l'on peut appliquer ce procédé en lieu et place de certains procédés de prétraitement, à des pièces métalliques fraichement usinées et qui doivent encore subir un traitement superficiel. Ainsi, dans le domaine des traitements galvaniques, sur pièces en laiton ou en acier par exemple, on a coutume de faire subir à ces pièces avant de les plonger dans le bain électrolytique, un traitement de décapage qui est suivi en général d'une simple opération d'égouttement. Or, l'application à ces pièces en lieu et place du traitement de décapage du procédé décrit a pour conséquence qui l'on obtient un état de surface apte à subir ensuite le traitement galvanique voulu sans qu'aucun résidus acide ou alcalin ne soit présent sur la surface des pièces. Dans ce cas, la température à laquelle s'effectue la réaction entre l'atmosphère de l'enceinte et les dépôts, en général d'oxydes, présents à la surface du métal, peut être choisie librement.

Comme on l'a dit plus haut, la construction de l'enceinte, la disposition du ou des générateurs, ainsi que la géométrie des supports des objets doivent faire l'objet de déterminations précises en fonction des lois de propagation des ondes électromagnétiques, que l'homme de l'art connait. Ainsi, la distance entre les ouvertures 20 et la paroi de cloisonnement 21 doit être choisie en fonction de la longueur d'ondes du générateur. Elle doit de préférence être supérieure à la valeur de cette longueur d'onde.

Le procédé décrit peut avoir une application notamment dans le domaine de la restauration des objets d'art ou anciens. Cependant, il est aussi susceptible d'applications dans d'autres domaines.

## Revendications

1. Procédé pour la restitution d'une structure métallique dans une surface dégradée d'un objet en métal par une action réductrice d'une atmosphère d'hydrogène à basse pression activée par une émission d'ondes électro-magnétiques à haute fréquence, caractérisé en ce que les ondes électro-magnétiques utilisées ont une fréquence choisie dans l'une de plusieurs bandes efficaces situées au-dessus de 400 MHz, en ce que les objets sont placés dans une enceinte dont les parois ont une action réfléchissante sur les ondes qui les frappent et en ce que la température des objets est réglée pendant la durée du traitement.

2. Procédé selon la revendication 1, caractérisé en ce que les bandes de fréquence utilisées sont les bandes de 915, 2'450, 5'800 et 22'215 MHz.

2. Procédé selon l'une quelconque des revendications 1 ou 2, caractérisé en ce qu'on règle la température durant le traitement de manière que l'objet ait une température constante, à une valeur comprise entre 40°C et 300°C.

4. Procédé selon la revendication 3, caractérisé en ce qu'on effectue le réglage de température en enclenchant et déclenchant alternativement une source d'énergie qui produit les dites ondes électro-magnétiques.

5. Application du procédé selon la revendication 1 ou l'une des revendications 2 à 4, à un prétraitement de la surface d'un objet métallique, ce prétraitement étant destiné à préparer l'objet en vue de la formation d'un revêtement par dépôt électrolytique, dépôt d'un enduit, projection de particules chargées ou non, etc.

6. Appareil pour la mise en oeuvre du procédé selon la revendication 1, comprenant une enceinte contenant des moyens de support d'objets à traiter, une pompe à vide, une source d'hydrogène, et un dispositif émetteur d'ondes électro-magnétiques, caractérisé en ce que le dit dispositif émetteur est agencé pour émettre dans au moins l'une de plusieurs bandes efficaces situées au-dessus de 400 MHz, et en ce que l'enceinte est entièrement constituée de parois réfléchissant les dites ondes et en ce que les moyens de support sont agencés pour maintenir les objets à distance des parois de l'enceinte.

7. Appareil selon la revendication 6, caractérisé en ce que le dispositif émetteur est agencé pour émettre dans l'une au moins des bandes de 915, 2'450, 5'800 et 22'125 MHz.

8. Appareil selon la revendication 7, caractérisé en ce que le dispositif émetteur comporte une ou plusieurs sources d'énergie reliées chacune à l'enceinte par un guide d'onde tubulaire ou un câble coaxial.

9. Appareil selon la revendication 8, caractérisé en ce que l'enceinte et les moyens de support des objets à traiter présentent une géométrie apte à diriger les dites ondes sur les objets à traiter.

10. Appareil selon l'une quelconque des revendications 6 - 9, caractérisé en ce qu'il comporte des moyens de réglage comportant un capteur de la température dans l'enceinte et des moyens d'enclenchement et de déclenchement du dispositif émetteur, pilotés de façon à maintenir une température prédéterminée et constante dans l'enceinte pendant le traitement.

11. Appareil pour la restitution d'une structure métallique sur des surfaces dégradées d'objets en métal, comprenant une enceinte fermée constituée de parois jointives, des moyens de fixation des dits objets dans l'enceinte, des moyens pour établir et entretenir dans l'environnement des dits objets une atmosphère de gaz réducteur à basse pression et un dispositif émetteur d'ondes électro-magnétiques aptes à activer le dit gaz réducteur et communiquant avec l'enceinte par une ou plusieurs ouvertures ménagées dans une ou des parois de l'enceinte, caractérisé en ce que les parois de l'enceinte sont conformées de manière à réfléchir les dites ondes électro-magnétiques, en ce qu'un cloisonnement en un matériau transparent pour les dites ondes et contenant la dite atmosphère est ménagé dans l'enceinte autour des dits objets et en ce que la distance entre la ou les dites ouvertures et le cloisonnement est suffisante pour qu'au moins une partie des ondes atteignent des parois de l'enceinte et se réfléchissent sur elles avant de traverser le cloisonnement.

12. Appareil selon la revendication 11, caractérisé en ce que le cloisonnement est en verre au borosilicate.

13. Appareil selon la revendication 11, caractérisé en ce que l'enceinte comporte des parois en aluminium, à faces internes planes.

# FIG. 1

FIG. 2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| D,A | SOVIET INVENTIONS ILLUSTRATED, classe K14, 18 mai 1983, no. 34274 K/14, Derwent Publications Ltd, Londres, GB; & SU-A-932 570 (INSTITUT DE PHYSIQUE DE L'ACADEMIE DES SCIENCES DE LA R.S.S. DE BIELRRUSSIE)<br>--- | 1,2,6,7 | H 01 J  37/32<br>C 25 D   5/34 |
| D,A | DE-A-3 011 686  (TOKYO SHIBAURA)<br>* Page 2, alinéa 1; page 5, alinéa 2; page 7, dernier alinéa - fin de la page 9 *<br>--- | 1,6 | |
| D,A | STUDIES IN CONSERVATION; JOURNAL OF THE INTERNATIONAL INSTITUTE FOR THE CONSERVATION OF HISTORIC AND ARTISTIC WORKS, vol. 31, février 1986, pages 29-37; J. PATSCHEIDER et al.: "Application of low-pressure hydrogen plasma to the conservation of ancient artifacts"<br>* Pages 29-31, paragraphes 1,2 *<br>--- | 1,6 | |
| A | PATENT ABSTRACTS OF JAPAN, vol. 3, no. 128 (C-62), 24 octobre 1979, page 96 C 62; & JP-A-54 107 876 (TOKYO SHIBAURA DENKI K.K.) 24-08-1979<br>--- | 1,6 | |
| A | EP-A-0 180 020  (IBM)<br>----- | | |

**DOMAINES TECHNIQUES RECHERCHES (Int. Cl.4)**

H 01 J   37/00
C 25 D    5/00
B 05 D    3/00
B 01 J   19/00

Le présent rapport a été établi pour toutes les revendications

| Lieu de la recherche | Date d'achèvement de la recherche | Examinateur |
|---|---|---|
| LA HAYE | 25-03-1988 | SCHAUB G.G. |